# EUROPEAN PATENT APPLICATION

(11) **EP 0 689 245 A2**
(43) Date of publication of application: **27.12.1995**
(21) Application number: 95109658.5
(22) Date of filing: 21.06.1995
(51) Int. Cl.: H01L 23/498, H01L 23/31

(54) **Electronic device, its arrangement and method of manufacturing the same**

(30) Priority: 22.06.1994 JP 140473/94; 10.08.1994 JP 188267/94; 31.03.1995 JP 100599/95
(71) Applicant: SEIKO EPSON CORPORATION, Shinjuku-ku Tokyo 163 (JP)
(72) Inventor: Hashimoto, Nobuaki, Suwa-shi, Nagano-ken, 392 (JP)
(74) Representative: Hoffmann, Eckart, Dipl.-Ing.

(57) **Abstract**

An object of the present invention is to provide a leadless package type electronic device, the cost and the size of which can be reduced and which exhibits excellent reliability, an electronic device arrangement for manufacturing the electronic devices, and a method therefor. The electronic device of a leadless package type includes a rectangular substrate (6) having a plurality of external electrodes (7) in the periphery thereof, an electronic element (1) placed on the surface of the substrate while being electrically connected to the external electrodes, and molding resin (5) for molding the element onto the surface of the substrate, wherein the surface of the molding resin is formed to be flat, and each side surface of the molding resin and each side surface of the substrate have the same surface.

## Description

The present invention relates to an electronic device having a printed circuit board, on which an IC chip, an LSI or the like is mounted, for use in personal or industrial electronic apparatuses, an electronic device arrangement and a method of manufacturing the electronic devices.

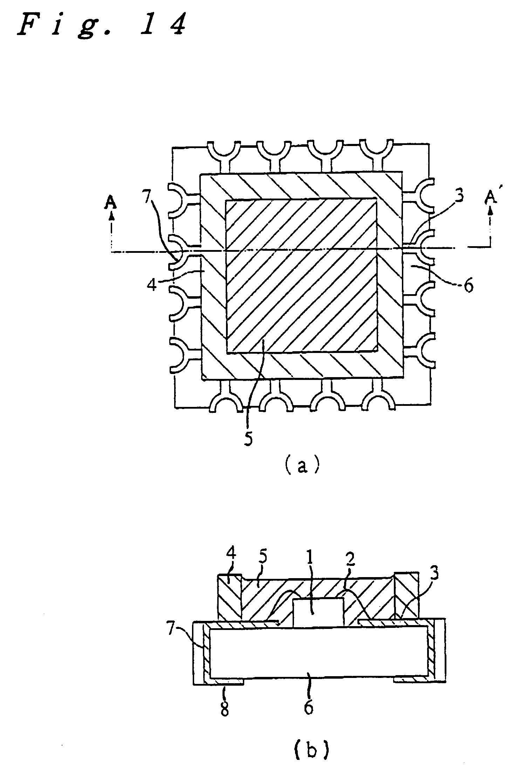

In recent years, significant progress established in the electronic technology has resulted in a reduced size, weight and thickness of a variety of personal and industrial electronic apparatuses, and their performance has been improved rapidly. In order to enlarge the circuit scale and to increase the number of the electronic devices, which can be mounted, attempts have been made to raise the mounting density and the operation speed by developing a variety of mounting techniques for connecting the electronic devices, as well as the technique for thinning the printed circuit board, that for finely patterning the same, employment of a multilayer structure and size reduction in the electronic device. As a technique for establishing the connection between an IC chip, an LSI or the like and the substrate, a chip-carrier-type electronic device structured as shown in Fig. 14 has been known.

Fig. 14A is a plan view of such a chip-carrier-type electronic device. Fig. 14B is a cross sectional view taken along line A-A' of Fig. 14A. As shown in Fig. 14B, in the electronic device a semiconductor device 1 is caused to die-attach a substrate 6 previously cut to have an outline passing through near the centers of rows of through holes 7. Furthermore, the semiconductor device 1 and circuit patterns 3 formed on the substrate 6 are electrically connected to one another by wires 2. The circuit patterns 3 are connected to the through holes (the external electrodes) 7 made to be electrically conducting. The through holes in turn are connected to connection lands 8 formed on the reverse side of the substrate 6. Furthermore, the connection between the circuit patterns 3 and a mother board (not shown) is, usually by soldering, established through the through holes 7 and the connection lands 8. Although the substrate 6 is usually a printed circuit board, a ceramic substrate is sometimes employed. The semiconductor device 1 caused to die-attach the substrate 6 is connected to the circuit patterns 3 by wire bonding, followed by being molded by molding resin 5.

A molding frame 4 constituting a dam is formed in the periphery of the surface of the substrate 6, the molding frame 4 raising the molding resin 5 to the level of the semiconductor device 1. The dam prevents undesirable flow of the molding resin 5 through the through holes 7 to the reverse side of the substrate 6. If the molding frame 4 is not used, the same purpose may be achieved by designing the substrate 6 so as to locate the through holes 7 relatively far away from the semiconductor device 1. Furthermore, a molding resin 5 of a type exhibiting excellent thixotropy (having a high thixotropic ratio, that is, resin flow is limited) has been employed.

However, the foregoing conventional chip-carrier-type electronic device encounters a problem in that the molding frame 4 must be formed on the substrate 6 involving an increase of costs, and another problem in that the molding frame 4 causes the size of the chip-carrier-type electronic device to increase.

In a case where the molding frame 4 is not used, the necessity for the through holes 7 to be located away from the semiconductor device 1 causes the size of the chip-carrier-type electronic device to be enlarged undesirably. Furthermore, since the molding resin 5 must have excellent thixotropy, that is, a molding material having a poor fluidity must be used, the molding resin 5 cannot easily be introduced into gaps adjacent to the semiconductor device 1. As a result, there arises a problem in that portions, which are not filled with the molding resin 5, are generated, and thus the reliability of the chip-carrier-type electronic device deteriorates.

Accordingly, an object of the present invention is to provide a leadless package type electronic device, which is capable of overcoming the foregoing problems, the cost and the size of which can be reduced and which exhibits excellent reliability. Another object of the invention is to provide an electronic device arrangement enabling simplified manufacturing the electronic devices. Still another object of the invention is to provide a method of manufacturing the electronic device.

These objects are achieved with an electronic device as claimed in claim 1, an electronic device arrangement as claimed in claim 12 and a method as claimed in claim 17, respectively.

Preferred embodiments of the invention are subject-matter of the dependent claims.

According to the electronic device as claimed in claim 1, the surface of the molding resin having a flat shape enables the total thickness to be uniform. Since each side surface of the molding resin has the same surface with each side surface of the substrate, the space can be used efficiently because a dam or the like can be omitted. Therefore, the area of the overall plane shape can be reduced.

According to the electronic device as claimed in claim 2, the external electrodes are formed by cutting through holes in the axial direction of the through holes. If solder or the like is not filled in the external electrodes or the like, use of the external electrodes as holes for locating a probe pin facilitates an electrical inspection.

According to the electronic device as claimed in claims 3 and 4, the external electrodes are filled with the conductive paste or the metal material having solderability so that handling easiness is improved. In a case where the external electrodes are soldered to a mother board or the like, fillets can easily be formed in the lower portions of the external electrodes adjacent to the mother board. Thus, soldering can easily be performed. Furthermore, the molding resin is not introduced into the external electrodes in the molding step, thus resulting in manufacturing being performed easily. In addition, members corresponding to the conventional dams can be omitted from the structure. Furthermore, the element parts and external electrodes are disposed closely. As a result, the manufacturing cost can be reduced and a compact overall shape can be realized. Furthermore, a molding material having low thixotropy, that is, exhibiting easy introduction capability can be used.

According to the electronic device as claimed in claims 5 and 6, solder or gold is used as the metal material so that easiness of soldering to the mother board is further improved.

The electronic device according to claim 7 comprises a covering member for covering openings of the external electrodes formed adjacent to the molding resin, wherein the side surfaces of the covering member are formed to have the same surface with each side surface of the molding resin and the substrate. Therefore, similarly to claims 3 and 4, introduction of the molding resin into the external electrodes in the molding step can be prevented. Thus, the manufacturing cost can be reduced, and a compact overall shape can be realized. Furthermore, a molding material having low thixotropy can be used.

The electronic device according to claim 8 comprises the pad disposed between the substrate and the element part and made of the same material as that of the covering member. Thus, the pad can be used as the locating reference at the time of mounting the element parts. Furthermore, a problem of a type that an end of the element part is placed on the covering member, and thus the element part is mounted while being inclined undesirably can be prevented.

Since the electronic device according to claim 9 has the structure that the pad has a penetrating hole, and a conductive member is included in the penetrating hole, the element part requiring a die pad and the die pad can be electrically conducted to each other so that their potentials are made to be the same.

The electronic device according to claim 10 has the structure that the covering member is an adhesive sheet, a dry film, a glass epoxy plate or a ceramic plate so that machining and attaching are easily performed. In particular, a photoprocess for use in the process for manufacturing a substrate can be applied to the dry film or the like. Therefore, machining and attaching can be performed more easily.

Since the electronic device according to claim 11 comprises the external electrodes at the corners of the substrate thereof, the printed patterns of the substrate can be disposed while being dispersed. Therefore, the corners of the substrate, that easily become dead spaces, can be used efficiently. Therefore, the printing pattern can be made adequately, and a compact overall shape can be realized because the dead space can be eliminated.

According to the electronic device arrangement as claimed in claim 12, the electronic device arrangement is cut along the imaginary lines so that leadless type electronic devices each comprising the substrate having external electrodes in the periphery thereof is constituted on which an element part is mounted and which is molded. The electronic device obtained by cutting has a structure that each side surface of the molding resin and each side surface of the substrate have the same surface so that electronic devices similarly to that according to claim 2 are manufactured. In the foregoing case, although the electronic device arrangement may be of a type from which one electronic device can be obtained by cutting, it is preferable that the electronic device arrangement be of a type in which a multiplicity of electronic device elements are included in a lattice configuration to enable a multiplicity of electronic devices to be obtained by cutting. Thus, compact electronic devices can be easily and quickly manufactured.

The electronic device arrangement according to claim 13 comprises the dams in the periphery of the substrate material thereof so that discharge of the molding resin from the substrate material is prevented in the molding step. Therefore, introduction (application) of the molding resin can be performed efficiently, and molding material having low thixotropy can be used.

The electronic device arrangement according to claim 14 further comprises the plating leads so that a plurality of electronic device elements can be simultaneously applied with plating. Since the electronic device elements are concentrically disposed, plating can be performed uniformly and efficiently.

Since the electronic device arrangement according to claim 15 has the plating leads disposed on the two sides of the substrate material, local concentration of the plating electric current can be prevented, and thus the thickness of plating can be equalized over the entire surface.

The advantages resulting from the structures according to claims 3 to 10 that have been explained above apply to the electronic device arrangement in the same way.

Since the electronic device arrangement according to claim 16 has the structure that the through holes are formed at intersection portions of lattice-like imaginary lines, the electronic devices obtained by cutting can be made to be similar to the electronic device according to claim 11 which comprises the through holes (the external electrodes) formed at the corners of the substrate.

The method of manufacturing electronic devices according to claim 17 causes the molding resin to be hardened through the substrate manufacturing step, the mounting step, the connection step and the molding step so that electronic device arrangement similar to that according to claim 12 is manufactured. Furthermore, the following cutting step enables electronic devices similar to that according to claim 2 to be obtained by cutting. Therefore, previous forming of a multiplicity of the electronic device elements on the electronic device arrangement will enable a multiplicity of electronic devices to be manufactured collectively. Furthermore, cutting causes each electronic device to have the same surface consisting of the side surface of the molding resin and the side surface of the substrate. Note that the cutting positions (lines) may be on the imaginary lines or slightly deviated from the imaginary lines if cutting is performed along the imaginary lines. Although it is preferable that the cutting method be dicing, breaking or the like may be employed.

The method of manufacturing electronic devices according to claim 18 has the arrangement that dams are formed in the periphery of the substrate material to prevent discharge of the introduced molding resin prior to performing the molding step. Thus, discharge of the molding resin to the outside of the substrate material can be prevented, and therefore introduction (application) of the molding resin can be performed efficiently. In addition, molding material having low thixotropy can be used. Furthermore, the molding resin can be applied uniformly.

The method of manufacturing electronic devices according to claim 19 has the structure such that the jig is used and the molding resin is hardened in a state where the substrate material is held horizontally so that the molding resin can be applied more equally.

The method of manufacturing electronic devices according to claim 20 has the structure such that the molding resin to be introduced is controlled by weight. Therefore, as compared with the conventional method in which the molding resin has been controlled by the time of discharge from a supply apparatus, the thickness accuracy of the molding resin can significantly be improved. It leads to a fact that the thicknesses of the electronic devices can be controlled accurately.

The method of manufacturing electronic devices according to claims 21 and 22 has the arrangement such that conductive paste is injected into the through holes prior to performing the molding step. Thus, an electronic device arrangement similar to that according to claim 12 in combination with claim 3 can be manufactured. By cutting the electronic device arrangement, electronic devices similar to that according to claim 3 can be manufactured.

Since the method of manufacturing electronic devices according to claim 23 has the arrangement that the metal material having solderability is injected into the through holes prior to performing the molding step, an electronic device arrangement similar to that according to claim 12 in combination with claim 4 can be manufactured. By cutting the electronic device arrangement, electronic devices similar to that according to claim 4 can be manufactured.

According to the method of manufacturing electronic devices according to claim 24, the solder paste is injected into the through holes, and then the solder paste is heated and melted so that the through holes are filled with solder. With the foregoing method, the substrate manufacturing technology using a stencil or a dry film can be applied so that injection of the solder can accurately and easily be performed.

The method of manufacturing electronic devices according to claim 25 has the arrangement such that opening portions of the through holes are brought into contact with the solder which has been melted and caused to wave. As a result, the solder is introduced into the through holes due to capillary phenomenon so as to be injected into the same. With the foregoing method, solder can quickly be injected, and the solder for mounting the electronic device onto a mother board can be previously supplied to the electronic device.

The method of manufacturing electronic devices according to claim 26 has the arrangement such that the substrate material is masked, and then the substrate material is immersed in molten solder. As a result, the solder is introduced and filled in only the through holes. The foregoing method enables the solder to be injected accurately and easily. By also employing the method according to claim 25, the solder can be injected accurately and quickly.

With the method of manufacturing electronic devices according to claim 27, the through holes are plated thickly so that the through holes are filled with the solder and a state is realized in which the through holes are filled with the plating material. The foregoing method enables a plating process for printing a pattern on the substrate material to be employed simultaneously. As a result, injection of the solder can significantly easily be performed.

The method of manufacturing electronic devices according to claim 28 comprises the closing step for, by using a closing member, closing an opening portion of each of the through holes opened in the reverse surface of the substrate material prior to performing the molding step; and an opening step for removing the closing member after the molding resin has been hardened. Therefore, air in each through holes is enclosed in the molding step to prevent undesirable introduction of the molding resin into the through holes. Therefore, covering members and injecting members, that are integrated with the electronic device, are not used to prevent introduction of the molding resin into the through holes.

The method of manufacturing electronic devices according to claims 29 and 30 has the arrangement that the closing step is performed such that the flat member is abutted to cover the entire surface of the reverse side of the substrate material. Thus, closing of all through holes can be performed collectively, and the opening step can significantly easily be performed. By using a silicon rubber flat member as the flat member at this time, close contact can be maintained even if the temperature is changed. Thus, a problem, such as undesirable discharge of enclosed air, can be prevented.

The method of manufacturing electronic devices according to claim 31 has the arrangement that the closing member comprises the adhesive sheet capable of covering the entire surface of the reverse side of the substrate material. Thus, desired close contact can be maintained without a necessity of pressing the adhesive sheet. As a result, the adhesive sheet can easily be attached to the substrate material.

The method of manufacturing electronic devices according to claims 32 and 33 has the arrangement that the sheet is the sheet, the adhesive property of which deteriorates with ultraviolet rays or heat. Thus, irradiation of the sheet with ultraviolet rays or heating of the same after the molding resin has been hardened enables the sheet to be separated easily even if the sheet has strong adhesiveness.

The method of manufacturing electronic devices according to claim 34 has the arrangement that the closing member is made of resin introduced into and hardened in each through hole, the resin being resin that is dissolved in an alkali water solution. Therefore, washing with an alkali water solution after the molding resin has been hardened, preferably after the cutting step has been performed, enables the closing member to be removed easily and completely from the electronic device.

The method of manufacturing electronic devices according to claim 35 has the arrangement that the covering material for closing the through holes is attached to the surface of the substrate material prior to performing the molding step. Thus, an electronic device arrangement similar to that according to claim 12 in combination with claim 7 can be formed after the molding resin has been hardened. Furthermore, the following cutting step enables electronic devices similar to that according to claim 7 to be manufactured.

The method of manufacturing electronic devices according to any of claims 36 to 38 has the arrangement that the covering material is the adhesive sheet, the dry film, the glass epoxy molded plate or the ceramic molded plate. Thus, machining and attaching can easily be performed. Furthermore, the electronic devices obtained by cutting can be made to be similar to that according to claim 10. By using glass epoxy prepreg or a ceramic green sheet and by heating and forcibly applying the same to be the covering material, machining can be performed further easily.

The method of manufacturing electronic devices according to claim 39 has the arrangement that the flatness-maintaining means for maintaining the flatness of the substrate material is attached prior to performing the molding step. Thus, warp of the substrate material occurring due to the difference in the coefficient of thermal expansion between the molding resin and the substrate material when the molding resin is hardened can be relaxed. As a result, the electronic devices obtained by cutting are free from warp and have excellent soldering easiness.

The method of manufacturing electronic devices according to claims 40 and 41 has the arrangement that the substrate material is again heated and then gradually cooled together with the hardened molding resin prior to removing the flatness-maintaining means. As a result, a relaxing phenomenon (the creeping phenomenon) due to the viscous component of the molding resin can be generated. Thus, the warp of the substrate material can further be relaxed. If the flatness-maintaining means is attached after the molding resin has been hardened, followed by heating and gradually cooling the substrate material, the creeping phenomenon can be generated.

The method of manufacturing electronic devices according to claim 42 has the arrangement that the flatness-maintaining means comprises a flatness maintaining plate and a holding member for holding both the flatness maintaining plate and the substrate material. Therefore, the flatness of the substrate material can be maintained, and the flatness-maintaining means does not interrupt the molding process. If the holding member is formed into a frame shape, the foregoing dam function is realized. The flatness maintaining plate may serve as the flat member according to claim 29.

The method of manufacturing electronic devices according to claim 43 enables an electronic device arrangement similar to that according to claim 14 to be formed by previously integrating the plating leads with the substrate material. Thus, a plurality of electronic device elements can collectively be applied with plating.

The method of manufacturing electronic devices according to claim 44 has the arrangement that the plating leads are, by half cutting, separated from the through holes prior to performing the cutting step, followed by performing electrical inspection of the element parts. Thus, the electronic device elements can be made electrically independent in the state of the electronic device arrangement. As a result, each electronic device element can be inspected in the foregoing state. Therefore, the inspection process can be simplified.

The method of manufacturing electronic devices according to claim 45 has the arrangement that semi-cutting is performed along the imaginary lines. Therefore, the cutting lines in the semi-cutting step and the complete cutting lines in the cutting step can be made to be the same. Thus, cutting can be performed efficiently.

The method of manufacturing electronic devices according to claim 46 has the arrangement that the adhesive sheet is applied to the entire surface of either side of the substrate material prior to performing the cutting step. Thus, dispersion of the cut electronic devices can be prevented similar to the process for dicing semiconductor wafer. As a result, a post process can be performed easily.

Other and further objects, features and advantages of the invention will be appear more fully from the following description, in which:
- Fig. 1: is a structural view of an electronic device according to an embodiment of the present invention;
- Fig. 2: is a diagram showing a manufacturing method corresponding to the embodiment shown in Fig. 1;
- Fig. 3: is an explanatory diagram showing another manufacturing method corresponding to the embodiment shown in Fig. 1;
- Fig. 4: is a structural view of an electronic device according to another embodiment of the present invention;
- Fig. 5: is an explanatory diagram showing a manufacturing method corresponding to the embodiment shown in Fig. 4;
- Fig. 6: is an explanatory diagram showing a manufacturing method corresponding to the embodiment shown in Fig. 4;
- Fig. 7 to 9: are structural views of electronic devices according to other embodiments of the present invention;
- Fig. 10: is an explanatory diagram showing a manufacturing method corresponding to the embodiments shown in Figs. 7 to 9;
- Fig. 11: is an explanatory diagram showing a method of manufacturing an electronic device according to an embodiment of the present invention;
- Fig. 12: is a structural view of a substrate of an electronic device according to an embodiment of the present invention;
- Fig. 13: is an explanatory diagram showing a method of manufacturing an electronic device according to an embodiment of the present invention; and
- Fig. 14: is a structural view of a conventional electronic device.

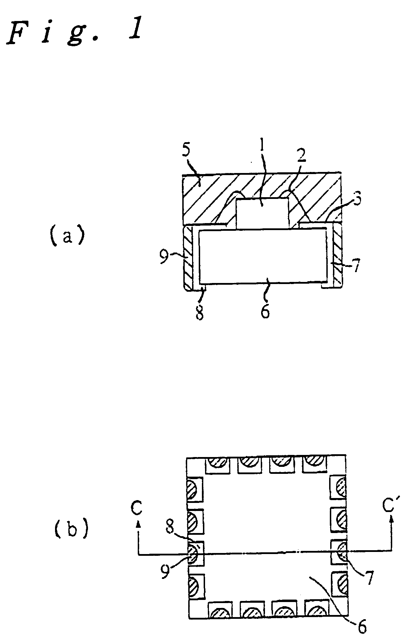

Preferred embodiments of the present invention will now be described with reference to the drawings. Fig. 1 is structural view of a chip-carrier-type (a lead-less package type) electronic device according to an embodiment of the present invention. Fig. 1B is a bottom plan view of the chip-carrier-type electronic device. Fig. 1A is a cross sectional view taken along line C-C' of Fig. 1B. As shown in Fig. 1A, the electronic device is structured such that a semiconductor device 1 is caused to die-attach a substrate 6 cut to have an outline passing through the centers or near the centers of rows of through holes 7 (external electrodes). Furthermore, the semiconductor device 1 and circuit patterns 3 formed on the substrate 6 are electrically connected to one another by wires 2.

Although the invention will be explained with reference to a semiconductor device 1 as an element mounted to the substrate, it is to be understood that the element may be a so-called passive device, such as an inductance device and a capacitance device, as well as an active device, such as the semiconductor device (IC, LSI or the like). Any device of an electronic apparatus that is or can be placed on a substrate may be employed here.

A portion of the circuit patterns 3 serves as bonding pads for use in wire bonding. The circuit patterns 3 are, by way of the through holes 7, electrically connected to connection lands 8 formed on the reverse side of the substrate 6 (external electrodes). The circuit patterns 3 are connected to a mother board (not shown) through the through holes 7 and the connection lands 8 by soldering. In one embodiment of the invention, the through holes 7 are filled with solder 9 to easily form solder fillets (solder hems) of the through holes 7 (on the side surfaces of the electronic device). As a result, the reliability of the electronic device can be improved as known, and the appearance inspection to be performed in a process of mounting the electronic device can easily be conducted.

Although the substrate 6 is usually a printed circuit board, a ceramic substrate may also be used. The molding resin 5 is, by a method to be described later, cut to have the same outline as that of the substrate 6. The die-attach of the semiconductor device 1 is usually established by an epoxy adhesive agent or silver paste. The wires 2 are usually gold or aluminum wires which are connected by a known wire bonding method. In a case where the substrate 6 is a printed circuit board, both the surface of the circuit patterns 3 and the inside of the through holes 7 usually have a structure such that copper foil is gold plated. In case of a ceramic substrate, the circuit patterns 3 usually have a structure such that copper, silver or tungsten paste is gold plated or are made of gold paste. In this case, the through holes 7 are, similarly to the printed circuit board, nickel or gold plated on plated copper. As an alternative to this, the through holes 7 may be filled with the foregoing conductive paste.

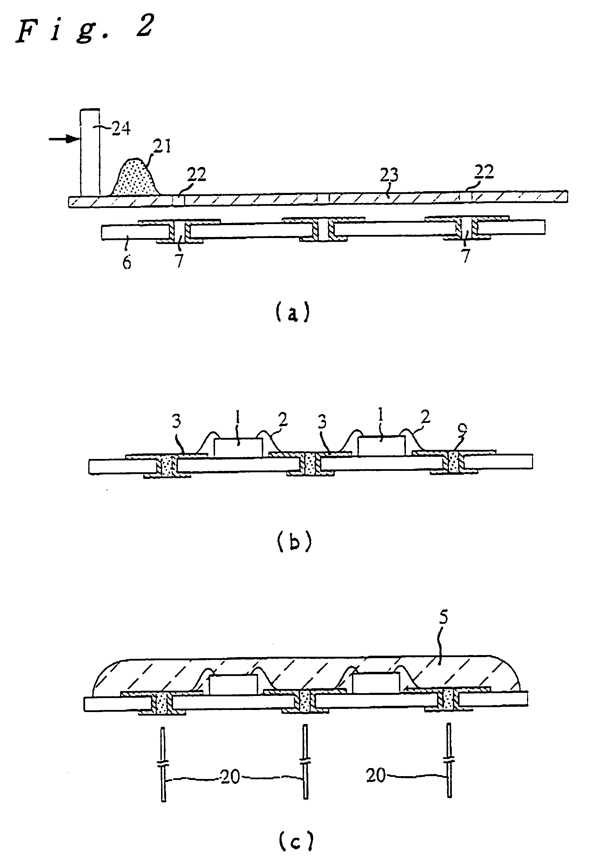

The conductive paste may be of a material containing copper, silver, gold or the like. In a particular case where an organic substrate is used as the substrate 6, it is preferable that a material containing copper be used for the conductive paste because its baking temperature is low. It is more preferable that conductive paste of a type such that copper particles are silver plated be used. The conductive paste is filled by a method comprising the steps of filling the through holes 7 with the conductive paste by a squeegee 24, and heating and hardening the conductive paste, similarly to the method for the solder 9 shown in Fig. 2 and explained below.

Although the through holes 7 are filled with the solder 9 in this embodiment, any material having solderability may be used. For example, gold or the like may be enclosed or conductive paste may be enclosed.

Referring to Fig. 2, a method of manufacturing the chip-carrier-type electronic device having the structure shown in Fig. 1 will now be described. As shown in Fig. 2A, the substrate 6, which has the through holes 7 previously formed at connection portions of a chip carrier, is prepared (Note that while the substrate 6 shown in Fig. 2 actually is a substrate material from which individual substrates will be cut later, the substrate material will sometimes also be referred to simply as "substrate" in this text and the same reference numeral will be used). Then, stencil 23 having apertures 22, which correspond to the through holes 7, are located such that the through holes 7 and the apertures 22 align to one another. Then, cream solder 21 is, by a squeegee 24, printed on a frame (not shown) which receives the substrate 6. At this time, the diameter of each aperture 22 of the stencil 23 is made to be the same as or slightly smaller than the diameter of the through holes 7 and/or the speed, at which the squeegee 24 is moved, and the pressure applied by the squeegee 24 are controlled to cause the cream solder 21 to be injected into only the through holes 7. Thus, the solder 9 can be injected into only the through holes 7 even if the solder 9 is melted later. Although the stencil 23 usually has a thickness of 100 µm to 200 µm, the quantity of the solder 9 to be injected is determined dependent on the volume of the through holes 7, and the thickness of the stencil 23 and the diameter of the apertures are determined correspondingly.

The solder 9 may be applied by any of known methods that have been employed in the surface mounting process. For example, a method using a dispenser may be employed. Then, the through holes 7 of the substrate 6 are heated by a reflow furnace, hot air or infrared rays to melt the cream solder 21 so that a state in which the through holes 7 are filled with the solder 9 is realized. If necessary, the through holes 7 are cleaned so that flux contained in the cream solder 21 is removed.

Note that, alternatively, a mask having openings corresponding to only the through holes 7 may be formed on either one or both sides of the substrate 6 by a resist or dry film, followed by printing the cream solder 21 to the substrate 6 to cause the solder 9 to be filled in only the through holes 7 with further improved reliability. The resist or dry film or the like is required to be removed after the solder 9 has been enclosed or the solder 9 has been melted. The foregoing method enables use of the stencil 23 to be omitted to fill only the through holes 7 with the cream solder 21 by placing the cream solder 21 directly on the substrate 6 and by squeeging with the squeegee 24.

Then, die-attach of the semiconductor device 1 is established, as shown in Fig. 2B, and then the semiconductor device 1 caused to die-attach and the circuit patterns 3 formed on each substrate 6 are electrically connected to one another by wires 2. Furthermore, as shown in Fig. 2C, potting is performed by applying the molding resin 5 to the substrate 6. At this time, since the through holes 7 have been filled with the solder 9, undesirable introduction of the molding resin 5 into the through holes 7 can be prevented, and therefore penetration of the molding resin 5 to appear on the reverse side of the substrate 6 can be prevented. As a matter of course, transfer molding using a costly mold which has a structure capable of relieving from the through holes 7 is not required, but the foregoing potting (molding) process using no mold is sufficient to achieve the desired object. Even if the transfer mold is used, the structure, in which the through holes 7 are filled with the solder 9, eliminates the necessity of employing the structure capable of relieving from the through holes 7. Furthermore simultaneous molding can be performed including the through hole surface on the wiring pattern side.

According to the present invention, if the potting is employed, neither is the periphery of the substrate 6 required to have a relatively wide area nor is a dam is required in the periphery of each substrate 6 to eliminate the necessity of using a molding material that exhibits excellent thixotropy. As a result, the molding resin 5 can satisfactorily be introduced into the gaps around the semiconductor device 1, and therefore portions that are not filled with the molding resin 5 are not generated. Thus, the reliability can be improved. If also vacuum defoaming is performed in the process for applying the molding resin 5, generation of portions that are not filled with the molding resin 5 can be prevented completely. If the surfaces of the substrates 6 and the semiconductor devices 1 are activated with oxygen or argon plasma immediately before the process for applying the molding resin 5 is performed, even better contact of the molding resin 5 can be established. As a result, the reliability of the electronic device can be improved more satisfactorily.

Then, the molding resin 5 is hardened by a hardening method, such as heating, irradiation with ultraviolet rays or allowing to stand in a wet environment. As a result of the foregoing processes, an arrangement of the electronic device can be manufactured in which a plurality of the semiconductor devices 1 are mounted on the substrate 6 (the substrate material) including the through holes 7 and having a large area, and then the molding resin 5 is applied to the upper surfaces of the these devices. That is, the electronic devices sharing the through holes 7 are formed on the substrate 6. Although a small number (one or two) of the electronic devices may be formed as illustrated, it is preferable that a plurality of the electronic devices be formed in the form of a matrix.

Finally, the arrangement of electronic devices is cut by a dicing blade 20 along the through holes 7 which constitute the outline of the chip-carrier-type electronic device, that is, along imaginary lines each of which passes through the centers or near the centers of the through holes 7. Thus, individual electronic devices can be obtained. The final cutting process may be, in place of performing dicing, carried out by a breaking process in which the substrate material is broken. In the latter case, the substrate 6 is previously provided with V-grooves or perforations along the imaginary lines passing through the centers or near the centers of the through holes 7.

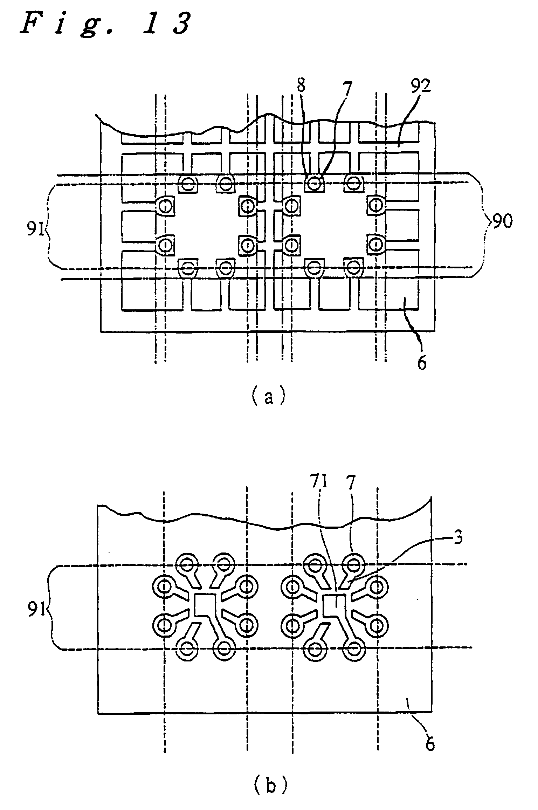

The structure may be constituted such that a plurality of the electronic devices are taken from one substrate 6, as described. In this case, it is preferable that the through holes 7 be shared by adjacent electronic devices if the positions of the through holes 7 of the adjacent electronic devices coincide with one another. In a case where the through holes 7 would otherwise be removed because of a corresponding thickness of the dicing blade 20, the substrate 6 is cut and the individual substrates 6 separated at positions slightly deviated from the centers of the through holes 7 to use only either side of the cut substrates 6 (see Fig. 13).

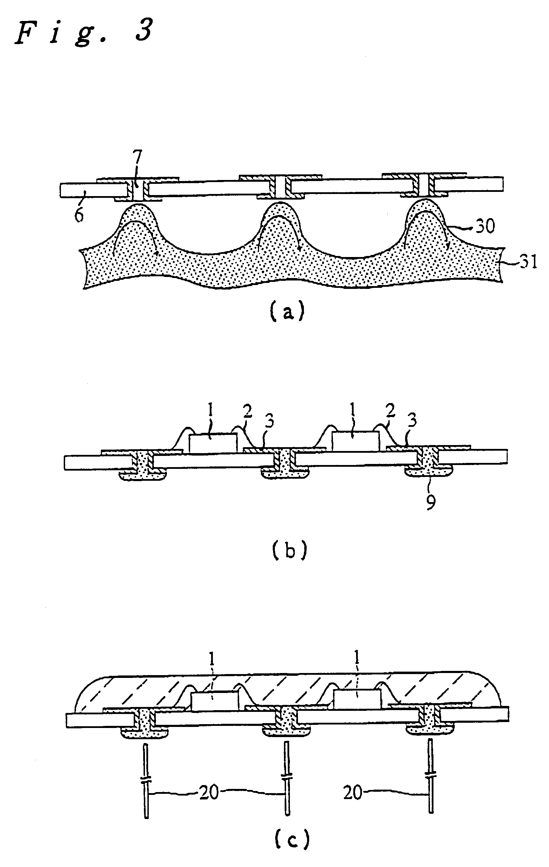

Referring to Fig. 3, another method of manufacturing the chip-carrier-type electronic device having the structure shown in Fig. 1 will now be described. As shown in Fig. 3A, a substrate 6 having through holes 7 at the connection portions of the chip carrier as shown in Fig. 3A is prepared. Then, flux is, by a flux applying apparatus (not shown), applied to only the opening portions of the through holes 7 of the substrate 6. Then, the substrate 6 is placed near and caused to face the liquid level of molten solder 31, followed by jetting out a solder stream 30 through nozzles or the like disposed to correspond to the through holes 7 so that the molten solder 31 is brought into contact with the opening portions of the through holes 7. If the diameter of each of the through holes 7 is about 0.5 mm or less, the capillary phenomenon causes the solder 9 to be drawn into only the through holes 7.

If a mask made of a resist or dry film and having openings corresponding to only the through holes 7 is placed on the surface of the substrate 6 to which the solder stream 30 is applied or on the two sides of the substrate 6, the solder 9 can accurately be injected into only the through holes 7. After the solder 9 has been injected, the resist or the dry film is removed. As a result of the foregoing manufacturing method, even if the substrate 6 is directly immersed in a soldering chamber, the solder 9 can be injected into only the through holes 7. Use of a solder resist to prevent excess extension of the solder 9 enables the solder 9 to be accurately injected into only the through holes 7. Cleaning is performed as the need arises to remove the flux.

The following processes are, as shown in Figs. 3B and 3C, the same as those described with reference to Fig. 2. Since the connection lands 8 on the reverse side of the substrate 6 are not masked with the resist or dry film in the processes shown in Figs. 3B and 3C, the solder 9 is supplied to the connection lands 8, as well as to the through holes 7. By previously supplying the solder 9 to also the connection lands 8 as described above, the soldering easiness can be improved when the electronic device obtained by cutting is mounted on the mother board by soldering. As an alternative to this, supply of the solder 9 to the connection lands 8 may be performed simultaneously with printing of the cream solder 21 performed as described with reference to Fig. 2. The supply may be performed simultaneously with performing the process of plating the through holes 7 to be described later.

Note that the through holes 7 may be previously and partially plugged with solder or by gold plating, or conductive paste may be used to plug the same, in place of the methods shown in Figs. 2 and 3. Since the connection with the mother board is usually established by soldering, it is preferable that the metal material to be injected into the through holes 7, which are the connection portions, be a material exhibiting excellent solderability. Specifically, it is preferable to use gold paste as the conductive paste rather than copper paste.

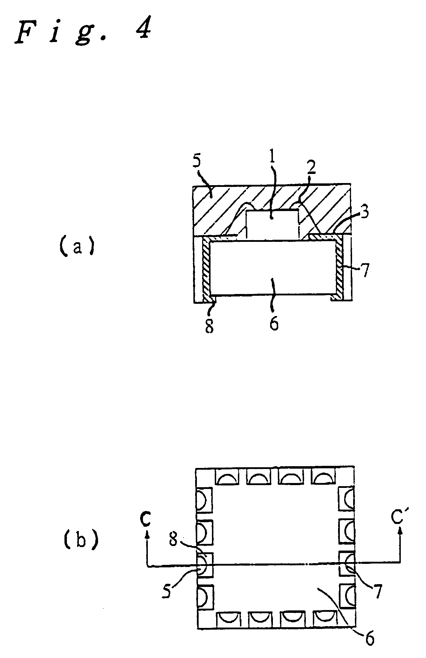

Another embodiment of the present invention will now be described. Fig. 4B is a bottom plan view of a chip-carrier-type electronic device. Fig. 4A is a cross sectional view taken along line C-C' of Fig. 4B. As shown in Fig. 4, the electronic device according to this embodiment has the same structure as that shown in Fig. 1 except that the through holes 7 (the external electrodes) of the electronic device shown in Fig. 1 are not filled with the solder 9. Since the solder 9 is not injected into the through holes 7, the structure can be simplified and the cost can be reduced. Since no metal material is injected into the through holes 7, the through hole 7 can be used as the locating hole for an inspection probe pin for use at the time of performing an electrical inspection of the electronic device to be performed as a later process. Thus, the electric conduction can reliably be established.

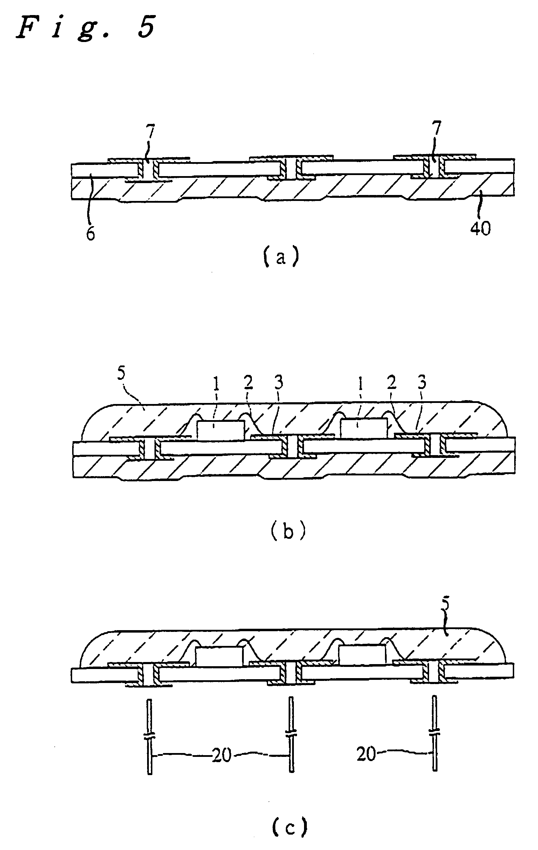

Referring to Fig. 5, a method of manufacturing the chip-carrier-type electronic device shown in Fig. 4 will now be described. As shown in Fig. 5A, a substrate 6 having through holes 7 formed at the connection portions of the chip carrier is prepared. Furthermore, an adhesive sheet 40 is applied to the whole reverse surface of the substrate 6. The adhesive sheet 40 may be any adhesive sheet which does not allow air to pass through. An adhesive sheet for use in the dicing process for the semiconductor device 1 is preferable to be employed because of its reliability attained due to a small quantity of impurities contained therein. Although the adhesive sheet 40 may be an adhesive sheet of a type that maintains its adhesiveness, it is preferable that it be a known adhesive sheet, the adhesiveness of which deteriorates when exposed to ultraviolet rays or heat because it can easily be separated in the later process. In the foregoing state, the semiconductor device 1 is caused to die-attach, as shown in Fig. 5B. Furthermore, the semiconductor device 1 and the circuit patterns 3 formed on the substrate 6 are electrically connected to one another by wires 2.

Then, potting of the molding resin 5 to the substrate 6 is performed with the opening portions of the through holes 7 formed on the reverse side of the substrate 6 covered with the adhesive sheet 40. Therefore, air is sealed in the through holes 7 so that undesirable introduction of the molding resin 5, which is adhesive fluid, into the through holes 7 can be prevented. Therefore, no special cover member is not required to prevent undesirable introduction of the molding resin 5 into the through holes 7. In case the molding resin 5 is a usual type molding resin having a viscosity of 20,000 to 50,000 centipoise, the foregoing effect has been confirmed if each through hole 7 has a diameter of 0.5 mm or less, though results of experiments are omitted here. Even if each through hole 7 has a diameter of 0.5 mm or more, the foregoing effect can be obtained by using a molding resin 5 having high viscosity.

In the foregoing state, the molding resin 5 is hardened, and then the adhesive sheet 40 is separated as shown in Fig. 5C. Then, the substrate 6 is, by a dicing blade 20, cut along the through holes (the imaginary lines) 7 so that individual electronic devices are obtained. The potting process may be performed by molding that requires no mold, and the molding resin 5 may be a molding resin having usual thixotropy, similarly to the embodiment shown in Fig. 2. If vacuum defoaming is, in the foregoing state, performed after the molding process has been performed, there is a risk that the molding resin 5 is undesirably introduced into the through holes 7. Therefore, vacuum defoaming must be, before the molding process is performed, limited to only the molding resin 5 to remove bubbles in the molding resin 5.

By employing the foregoing manufacturing method, the gold-plated through holes (the external electrodes) 7 appear on the side surfaces of the electronic devices formed by cutting. Thus, solder fillets can easily be formed in the through holes 7 when the connection with the mother board is established, causing the electronic device to have improved soldering easiness. If a ceramic substrate is used, a similar effect to that obtainable from the foregoing printed board can be obtained if the through holes 7 are kept hollow. If the conductive paste is injected, the same structure described with reference to Fig. 1 is employed.

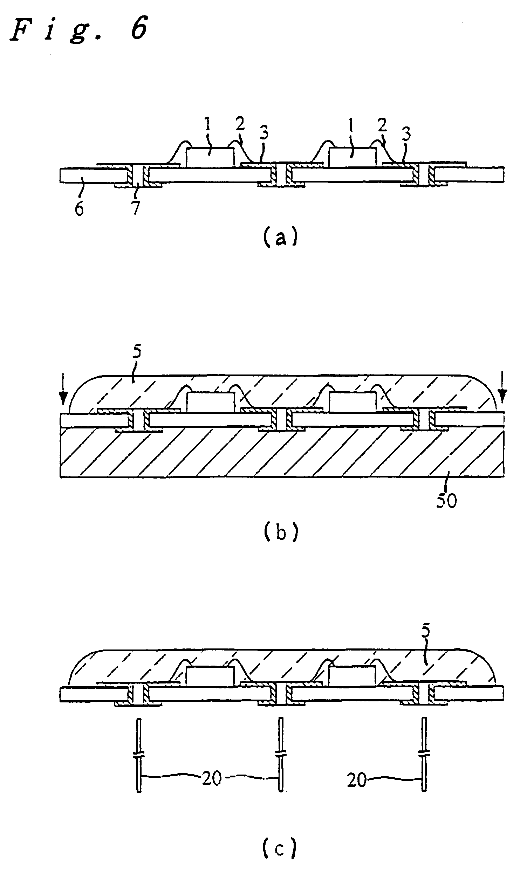

Another method of manufacturing the chip-carrier-type electronic device having the structure as shown in Fig. 4 will now be described with reference to Fig. 6. As shown in Fig. 6A, a substrate 6 having through holes 7 previously formed in the connection portions of the chip carrier is prepared, followed by causing the semiconductor device 1 to die-attach the upper surface of the substrate 6. Furthermore, the semiconductor device 1 and the circuit patterns 3 formed on the substrate 6 are electrically connected to one another by wires 2. Then, as shown in Fig. 6B, silicon rubber 50 is pressed against the reverse side of the substrate 6 to cover the through holes 7, followed by potting the molding resin 5, which is then hardened as it is. The reason why the molding resin 5 is not introduced into the through holes 7 is due to the same principle as that in the foregoing case where the adhesive sheet 40 is used. As shown in Fig. 6C, the following process is the same as that described with reference to Fig. 5.

In order to improve the contact between the through holes 7 and the silicon rubber 50 to reliably maintain air in the through holes 7, each of the portions of the silicon rubber 50 which is in contact with the through holes 7 and that with the connection lands 8 that protrude from the substrate surface may previously be formed into a corresponding recessed shape to receive those protruding portions. As an alternative to this, pin-like projections may be formed on the surface of the silicon rubber 50 to plug the inside portions of the through holes 7.

To prevent introduction of the molding resin 5 into the through holes 7, the through holes 7 may be plugged by a known method of plugging a hole with resin that is employed by a known step of the method of manufacturing a substrate 6, followed by removing the plugging resin after the dicing process has been completed. In the foregoing case, resin of a type that is dissolved in an alkali water solution is usually used to remove the resin after the dicing process has been completed, the removal being performed such that the resin is washed off.

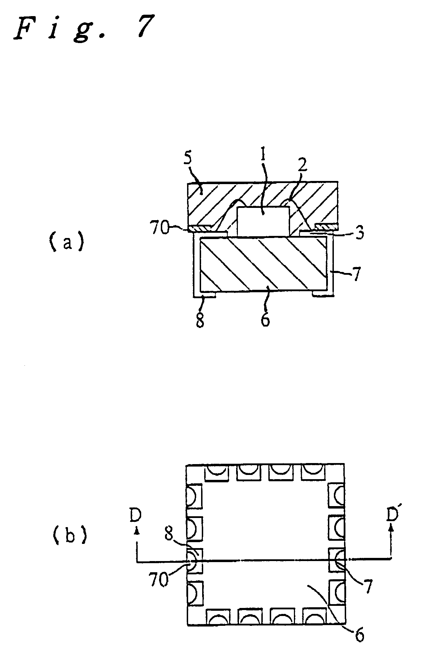

Another embodiment of the present invention will now be described. Fig. 7 is a structural view of a chip-carrier-type electronic device according to this embodiment of the present invention. Fig. 7B is a bottom plan view of the chip-carrier-type electronic device. Fig. 7A is a cross sectional view taken along line D-D' of Fig. 7B. As shown in Fig. 7, the electronic device according to this embodiment has through-hole covering members 70 previously placed on the through holes (the external electrodes) 7. The semiconductor device 1 is caused to die-attach the upper surface of the substrate 6 cut to have an outer shape passing through the centers or near the centers of the through holes 7. Furthermore, the semiconductor device 1 and the circuit patterns 3 formed on the substrate 6 are electrically connected to one another by wires 2.

The through-hole covering members 70 are disposed on only the through holes 7 and comprise, for example, dry films, glass epoxy plates or ceramic plates each of which has adhesiveness and is used in the process for manufacturing a substrate. In this case, the through-hole covering members 70 are manufactured by, with a pattern, punching to have shapes that can be placed on the through holes 7, followed by being applied to the substrate 6. As a matter of course, if the dry film is used, it is applied to the entire surface of the substrate 6, followed by leaving the required portions corresponding to the through holes 7 in a photoprocess similar to that employed in a conventional technology of manufacturing a substrate.

A glass epoxy plate, previously formed, may be applied to the substrate 6 by an adhesive agent, or a prepreg of an unformed glass epoxy plate may be previously formed by pattern drawing or the like, followed by being located, and then it is heated and forcibly applied to the surface. If the substrate 6 is made of ceramics, a non-sintered green sheet may be previously formed by pattern drawing or the like, followed by being located, and then the green sheet is, together with the substrate 6, heated and pressurized so that the green sheet is sintered to the substrate 6. Note that the basic structure except the through-hole covering members 70 is the same as that of the electronic devices shown in Figs. 1 and 4.

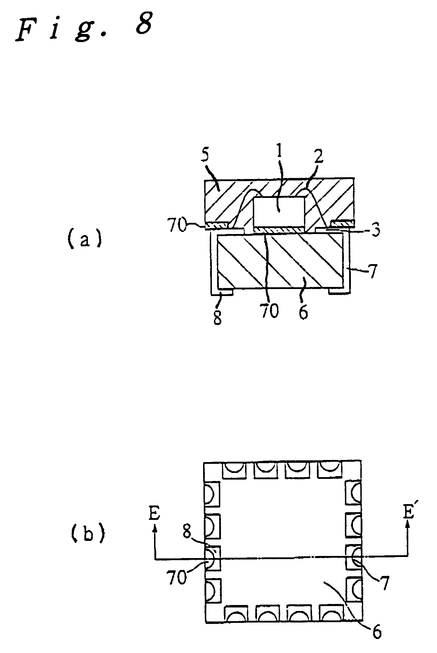

Another embodiment of the present invention will now be described. Fig. 8 is a structural view of a chip-carrier-type electronic device according to another embodiment of the present invention. Fig. 8B is a bottom plan view of the chip-carrier-type electronic device. Fig. 8A is a cross sectional view taken along line E-E' of Fig. 8B. As shown in Fig. 8, the electronic device according to this embodiment has a structure such that the through-hole covering members 70 are disposed between the semiconductor device 1 and the substrate 6, as well as on the through holes (the external electrodes) 7. That is, the semiconductor device 1 is not caused to directly die-attach the substrate 6, but is caused to die-attach the upper surface of the through-hole covering members (pads) 70. Apart from the foregoing difference the structure is the same as that shown in Fig. 7.

Therefore, the through-hole covering members 70 are required to be opened in the portions in which the wires 2 are connected to the circuit patterns 3. In the case where the through-hole covering members 70 comprise the sheets having adhesiveness, the glass epoxy plates or the ceramic plates, the necessity of forming the punched openings by using a costly pattern, as is required in the case shown in Fig. 7, can be eliminated. The punched openings may be formed by a drill bit. Furthermore, the semiconductor device 1 can easily be located. If the structure shown in Fig. 8 is employed, the through-hole covering members 70 can easily be manufactured and the semiconductor device 1 can easily be mounted as compared with the structure shown in Fig. 7. Thus, the cost of the electronic device can be lowered.

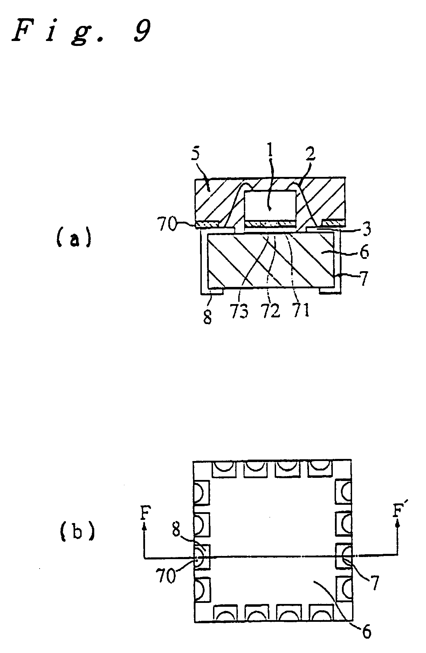

Another embodiment of the present invention will now be described. Fig. 9 is a structural view of a chip-carrier-type electronic device according to this embodiment of the present invention. Fig. 9B is a bottom plan view of the chip-carrier-type electronic device. Fig. 9A is a cross sectional view of the chip-carrier-type electronic device taken along line F-F' of Fig. 9B. As shown in Fig. 9, the electronic device according to this embodiment has a structure such that the through-hole covering members (pads) 70 disposed between the semiconductor device 1 and the substrate 6 shown in Fig. 8 have penetrating holes 73. The penetrating holes 73 are filled with silver paste 72. The silver paste 72 establishes electrical connection between a die pad 71 formed on the substrate 6 and the reverse side of the semiconductor device 1.

In general, the die pad 71 is connected to a certain fixed potential. Therefore, the structure shown in Fig. 9 is effective in a case where the potential of the die of the semiconductor device 1 must be fixed. Also in this case, the through-hole covering members 70 are required to have openings to correspond to the portions, in which the wires 2 are connected to the circuit patterns 3, and the portions of the foregoing penetrating holes 73. Therefore, if the sheet having adhesiveness, the glass epoxy plate or the ceramic plate is used as the through-hole covering members 70, the through-hole covering members 70, which have been machined by a drill bit and the cost of which can therefore be reduced, may be applied similarly to the structure shown in Fig. 8.

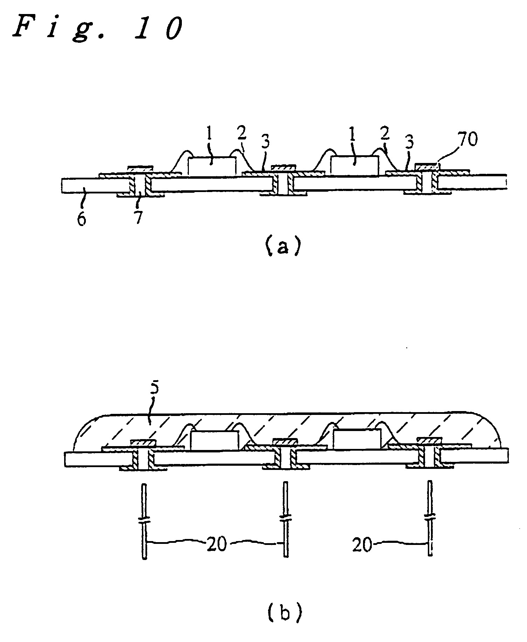

A method of manufacturing the chip-carrier-type electronic device having the structure shown in Figs. 7 to 9 will now be described with reference to Fig. 10. As shown in Fig. 10A, the substrate (the substrate material) 6 having the through holes 7 formed at the connection portions of the chip carrier is prepared. Then, the through-hole covering members 70 are attached onto the through holes 7. The through-hole covering members 70 are required to be formed by punching with a pattern or the like to locate the dry film, the glass epoxy plate or the ceramic plate, each of which is used in the technique for manufacturing substrates, on only the through holes 7, before it is applied to the substrate 6. In the case where the dry film is used, it is applied to the entire surface of the substrate 6, followed by leaving only the portions corresponding to the through holes 7 in a process similar to that employed in the conventional technique for manufacturing substrate.

As shown in Fig. 10A, the through-hole covering members 70 may be disposed to cover only the through holes 7. Alternatively, they may be further disposed between the semiconductor device 1 and the substrate 6 to serve as the pad for the semiconductor device 1, as described with reference to Figs. 8 and 9. Then, the semiconductor device 1 is caused to die-attach. The semiconductor device 1, which has been brought to the die-attach, and the circuit patterns 3 formed on the substrate 6 are electrically connected to one another by the wires 2. Furthermore, potting is performed by applying the molding resin 5 onto the substrate 6, as shown in Fig. 10B. Since the through holes 7 are covered with the through-hole covering members 70, undesirable introduction of the molding resin 5 into the through holes 7 can be prevented. Thus, undesirable penetration of the molding resin 5 to appear on the reverse side of the substrate 6 can be prevented. Finally, similarly to Fig. 2C, the electronic device arrangement is cut by the dicing blade 20 along the rows of through holes 7, which define the outline of the chip-carrier-type electronic device, that is, along imaginary lines passing through the centers or near the centers of the through holes 7. Thus, individual electronic devices are be obtained.

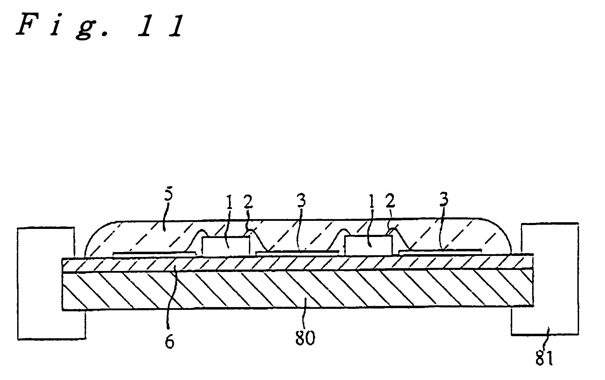

Referring to Fig. 11, a method of manufacturing another electronic device will now be described. Similarly to the plurality of the embodiments above, the semiconductor device 1 is caused to die-attach and wire bonded. Then, the potting is performed. In this embodiment, a flatness-maintaining means for maintaining the flatness of the substrate 6 when the molding resin 5 is hardened is attached to the substrate 6. The flatness-maintaining means comprises a flatness-maintaining plate 80, which is placed onto the reverse side of the substrate 6, and holding members 81 for holding both the flatness-maintaining plate 80 and the substrate 6 therebetween, the holding members 81 each having a U-shape cross sectional shape with the openings arranged to face each other. The holding members 81 are detachably attached to the substrate 6. In this state, the molding resin 5 is hardened by a method suitable for thetype of molding resin 5 employed. Since the molding resin 5 is composed of thermosetting-type epoxy resin in general, the molding resin 5 is hardened in a thermostatic chamber.

The coefficient of thermal expansion (which is 2 to 3 x 10⁻⁵/°C for a usual resin) of the molding resin 5 is larger than the coefficient of thermal expansion (which is about 1.5 x 10⁻⁵/°C for FR-4, which is a typical example) of the substrate. Furthermore, the molding resin 5 is contracted by several to tens of % when hardened. Therefore, if the molding resin 5 is made to harden with the substrate 6 left as it is, the substrate 6 is warped into a concave shape relative to the molding resin 5. However, if the molding resin 5 is hardened in a state where the flatness-maintaining means is attached to the substrate 6, the relaxing phenomenon (the creeping phenomenon) of the viscous component of the molding resin 5 relaxes the degree of the warp of the substrate (in the foregoing state, it is the electronic device arrangement) 6. Consequently, the warp of the substrate 6, from which the flatness-maintaining means has been removed, can be prevented satisfactorily. Therefore, an advantage can be attained in later processes, such as the dicing process, the probing electrical characteristic inspection and the like, which require the flatness of the substrate 6. Note that also the warp of the electronic devices, which are the final products, can, of course, be prevented satisfactorily.

If the flatness-maintaining means is attached to the warped substrate 6 as shown in Fig. 11 after the molding resin 5 has been hardened, and the substrate (the electronic device arrangement) 6 is again heated followed by being cooled gradually, the warp of the substrate 6 can be relaxed. The foregoing process is a process generally called "annealing", which is also due to the relaxing phenomenon (the creeping phenomenon) of the viscous component of the molding resin 5. As a matter of course, combination of the process for hardening the molding resin 5, in a state where the flatness-maintaining means is attached to the substrate 6, and a process for annealing the substrate 6, in a state where the flatness-maintaining means is attached to the substrate 6, will further prevent the warp of the substrate 6.

An effective method of applying the molding resin in the method of manufacturing the electronic devices according to this embodiment will now be described. Although illustration is omitted here, the method of applying the molding resin is such that the quantity of the molding resin to be applied onto the substrate is controlled by weight. Namely, the area, to which the molding resin is applied, is determined by the subject substrate. The specific gravity of the molding resin (in case of a thermosetting epoxy resin) is about 1.8. The control of the molding resin to be applied by weight will enable the thickness of the applied molding resin to be controlled. By considering the volume of the elements to be molded, such as the semiconductor device, the thickness of the applied molding resin can be controlled accurately. Thus, the molding resin can be applied with a thickness accuracy of 0.8 mm to 0.9 mm on a substrate having a thickness of 0.4 mm. As a result, generation of cracks during the molding process can be prevented, and the thickness of the electronic device can be minimized.

Furthermore, the method of applying the molding resin according to this embodiment comprises holding the substrate, to which the molding resin has been applied, horizontally during the process for hardening the molding resin. That is, jigs for horizontally holding the substrate are used such that the molding resin is hardened in a state where the substrate is held horizontally in a thermostable chamber. As a result, the thickness of the applied molding resin for the electronic device arrangement can be made uniform. Thus, the thickness of the molding resin applied to the electronic devices obtained by cutting can be made equal, causing the thicknesses of the electronic devices to be made equal. As a means for weighing the molding resin, any of adequate balances, exemplified by an electronic balance, may be employed. As the foregoing jigs, it might be considered feasible to employ a three-point-suspension (three legs, the height of each of which can be adjusted) frame having a level.

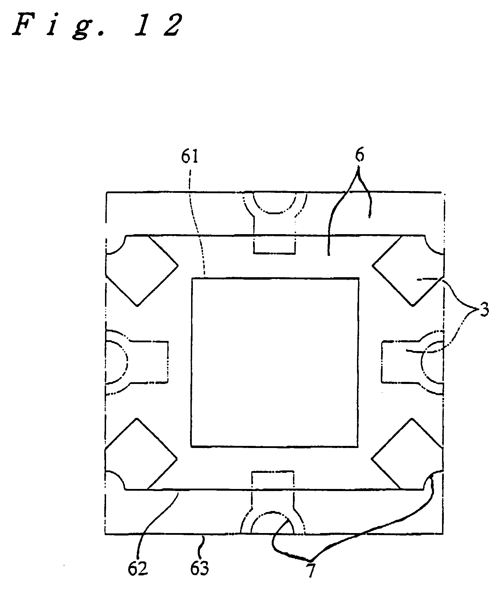

Another embodiment of the present invention that can be applied to any of the foregoing structures of the electronic devices will now be described. Fig. 12 is a structural view of the substrate of a chip-carrier-type electronic device according to this embodiment of the present invention. In this drawing two types of substrate structures are superimposed for comparison. Referring to Fig. 12, reference numeral 61 represents a die-attach portion of the semiconductor device common to the two types of substrate structure. The substrate 6, the circuit patterns 3 and the through holes 7 are designated by continuous lines in a substrate structure 62, while the same are designated by an alternate long and two short dashes line in another substrate structure 63. The continuous line designates the substrate structure 62 according to this embodiment in which the four corners of the substrate 6 have through holes 7 and circuit patterns 3 that also serve as bonding pads for use in the wire bonding process. The alternate long and two short dashes line designates the conventional substrate structure 63 in which the four corners of the substrate 6 have the through holes 7 and the circuit patterns 3.

In a particular case where the semiconductor device 1 and the circuit patterns 3 are connected, the number of which is four or less, the size of the electronic device is minimized and the electronic device has a regular size, it is, as can be understood from Fig. 12, advantageous to reduce the size of the substrate in a case where the through holes 7 be formed at the four corners of the substrate 6 in place of forming the same on the sides of the substrate 6 to efficiently use the four corners of the substrate 6, which easily become dead spaces. If the semiconductor device 1 and the circuit patterns 3 are connected by three or less lines, use of all four corners of the substrate 6 is not required. When the electronic device having the substrate structure 62 is manufactured, a substrate (substrate material) 6 having through holes 7 formed at intersections of imaginary lines, which become cut lines later, is prepared so that electronic device arrangement is manufactured, followed by being cut along the imaginary lines.

Referring to Fig. 13, another manufacturing method that can be applied to any chip-carrier-type electronic device will now be described. The process for cutting the substrate 6 to be described below is performed after the semiconductor device 1 is mounted and the molding resin 5 has been applied, as described above. To simplify the description, the semiconductor device 1 and the wires 2 are omitted from illustration. Fig. 13A is a bottom plan view of the substrate (the substrate material) 6 for use in a chip-carrier-type electronic device according to the present invention. Fig. 13B is a plan view of the substrate 6.

Referring to Fig. 13B, reference numeral 71 represents a die pad to which the semiconductor device 1 die-attaches. The semiconductor device 1 and the circuit patterns 3 are connected to one another, the latter in turn being connected to the reverse side of the substrate 6 by way of the through holes 7. A dashed line in Fig. 13B represents a full dicing line (an imaginary line) 91. A region surrounded by the lines 91 is the outline of the chip-carrier-type electronic device. As a matter of course, the molding resin 5 is, in the actual process, applied to the entire surface of the substrate 6, and therefore the circuit patterns 3, the through holes 7 and the like shown in Fig. 13B cannot be seen. The appearance of the reverse side of the substrate 6 shown in Fig. 13A is, before the dicing process, not changed before and after the mounting process.

As shown in Fig. 13A, the periphery of the reverse side of the substrate 6 has plating leads 92 that are connected to through holes 7. The plating leads 92 are used for subjecting the circuit patterns 3 on the surface of the substrate 6, the through holes 7 and the connection lands 8 on the reverse side of the substrate 6 to electric plating. Therefore, the plating leads 92 electrically short-circuit all of the through holes 7, the circuit patterns 3 connected to the through holes 7, and the outer wiring portions of the semiconductor device 1.

After plating has been applied, the short-circuit state is canceled by cutting the plating leads 92 by half dicing lines 90 in this embodiment. Half dicing is, in this embodiment, performed at a depth at least exceeding the thickness of the plating lead 92 and smaller than the total thickness of the electronic device including the mold. In the foregoing case, it is preferable that scattering of the chip-carrier-type electronic devices occurring in the later full dicing process be prevented by applying a sheet having adhesiveness to the surface of the molded substrate 6. Since the plating leads 92 are cut in the half dicing process, the electrical short circuit of all of the through holes 7, the circuit patterns 3 connected to the through holes 7, and the outer wiring portions of the semiconductor device 1 is canceled. Thus, the portion from the through holes 7 to the semiconductor device 1 is, similar to the final chip-carrier-type electronic device, an electronic device element that is electrically independent. As a result, by standing erect a pin probe in the through hole 7, the portion from the reverse side of the substrate 6 to the semiconductor device 1 can be electrically inspected. After the inspection has been completed, cutting along the full dicing lines 91 is performed to have the final shape of the chip-carrier-type electronic device.

As a result, the chip-carrier-type electronic device can be inspected in the state of the outline of the substrate. Therefore, the inspection and locating can easily be performed as compared with the case where an independent electronic device is inspected. The half dicing lines 90 and the full dicing lines 91 may be superimposed. That is, a similar effect can be obtained if half dicing is performed at the outline position of the final chip-carrier-type electronic devices and full dicing is performed at the same position after the parts have been inspected, followed by being manufactured to the final chip-carrier-type electronic devices.

Half dicing may be omitted to perform full dicing along the foregoing full dicing lines 91, followed by being manufactured to the final chip-carrier-type electronic devices. Also in this case, a sheet having adhesiveness is applied to the surface of the substrate 6. As a result, scattering of the electronic devices which have been fully diced can be prevented, and also the plating leads 92 can be cut. Therefore, the chip-carrier-type electronic devices can be inspected in a state of an electronic device arrangement.

Although omitted from illustration, the plating leads 92 may be formed on each of the two sides of the substrate 6. In the foregoing case, local passing of the plating electric current can be restricted. Thus, the thickness of plating can be made equal. In the foregoing case, it is preferable that full dicing be directly performed.

Although the foregoing embodiments have been described with respect to a method in which the semiconductor device is mounted on the substrate by a so-called wire bonding method, it may, of course, be mounted by another known method, such as a TAB method, a flip chip method or the like. If the semiconductor device is mounted by the flip chip method using the face-down method, the area required to arrange the wires can be reduced. Therefore, the size of the electronic device can, of course, be reduced. Furthermore, although the foregoing embodiments have been described based on a structure in which the semiconductor device is mounted on the chip-carrier-type electronic device, the element to be mounted is not limited to the semiconductor device. Any element, such as a capacitor, an inductor or the like, may be mounted. Furthermore, a plurality of elements may be mounted on the substrate according to each embodiment, as well as the single element. As a matter of course, the substrate may be used as a package on which a so-called an MCM (Multi-Chip Module) is mounted.

Since the present invention is structured as described above, the following effects can be obtained.

Since the electronic device as claimed in claim 1 has the structure such that the surface of the molding resin is formed to be flat, the total thickness can be made equal and decreased. Furthermore, since no dam is provided, the structure can be simplified and the area of the plane shape can be reduced. In addition, the through holes are used to facilitate the electrical inspection. As a result, the electronic device can be manufactured with a low cost while reducing the size. By injecting metal material having solderability into the through holes, a dam can be omitted from the structure and soldering facility can be improved. Thus, the size of the electronic device can be reduced, and the reliability can be improved. Similarly, the size can be reduced by providing the covering members for covering the opening portions of the through holes. In addition, the through holes are formed at the corners of the substrate so that the size of the electronic device can be reduced.

The electronic device arrangement as claimed in claim 12 of the present invention enables a multiplicity of electronic device elements, to be formed into independent electronic devices, to be manufactured simultaneously. Furthermore, the electronic devices according to claim 2 can be manufactured (obtained by cutting) efficiently. By providing the dams for the substrate material, the molding resin can be equally and satisfactorily applied to each electronic device element. Furthermore, the provided plating leads enable each electronic device element to be simultaneously subjected to plating.

According to the method of manufacturing electronic devices as claimed in claim 17, a multiplicity of the electronic devices according to claim 2 can be manufactured simultaneously. That is, electronic devices can be efficiently manufactured with a reduced cost while reducing the size thereof. By controlling the molding resin by weight and by hardening the same in a state where it is held horizontally, the electronic devices can be formed to have the minimum thickness while maintaining the molding reliability. When the molding resin is hardened, the flatness-maintaining means is used so that the flatness of the substrate can be maintained accurately with a simple method. Thus, the reliability of the electronic device can be improved. Furthermore, the electrical inspection can be performed in a state before cutting the same to be formed into individual electronic devices. Therefore, the inspection process can be simplified.

Although the invention has been described in its preferred form with a certain degree of particularity, it is understood that the present disclosure of the preferred form can be changed in the details of construction and the combination and arrangement of parts may be resorted to without departing from the spirit and the scope of the invention as hereinafter claimed.

## Claims

1. An electronic device of a leadless package type comprising:
a rectangular substrate (6) having a plurality of external electrodes (7) in the periphery thereof; and
an electronic element (1) disposed on the surface of said substrate and being electrically connected to said external electrodes, said electronic element being molded on said substrate by molding resin (5);
wherein the the upper side of said molding resin is flat, and each side surface of said molding resin and each side surface of said substrate are in the same plane, respectively.

2. The device according to claim 1, wherein said external electrodes comprise through holes (7) cut in the axial direction through said substrate.

3. The device according to claim 2, wherein said through holes (7) are filled with conductive paste.

4. The device according to claim 2, wherein said through holes (7) are filled with metal material (9) that has solderability.

5. The device according to claim 4, wherein said metal material is solder.

6. The device according to claim 4, wherein said metal material is gold.

7. The device according to any one of claims 2 to 6 further comprising a covering member (70) for covering said through holes (7) below said molding resin (5), wherein
the side surfaces of said covering member are flush with each side surface of said molding resin and said substrate (6).

8. The device according to claim 7 further comprising a pad (71) disposed between said substrate (6) and said electronic element (1) and made of the same material as said covering member (70).

9. The device according to claim 8, wherein said pad (71) has a penetrating hole (73) that penetrates said covering member (70), and a conductive member (72) for electrically connecting said electronic element and a circuit region of said substrate to each other is included in said penetrating hole.

10. The device according to any of claims 7 to 9, wherein said covering member (70) is an adhesive sheet, a dry film,a glass epoxy plate or a ceramic plate.

11. The device according to any of claims 1 to 10, wherein said external electrodes (7) are disposed at the corners of said substrate.

12. An electronic device arrangement comprising a plurality of electronic devices as defined in any of the claims 2 to 11 with the respective substrates (6) still connected to form a substrate material wherein said through holes (7) are disposed on lattice-like imaginary lines surrounding said electronic elements (1), said through holes defining lines passing through substantially the centers thereof along which to cut said arrangement into individual devices.

13. The arrangement according to claim 12 further comprising dams disposed in the periphery of said substrate material to prevent discharge of said introduced molding resin.

14. The arrangement according to claim 12 or 13 further comprising plating leads (92) provided on said substrate material and electrically connecting said through holes (7).

15. The arrangement according to claim 14, wherein said plating leads (92) are disposed on two sides of said substrate material.

16. The device arrangement according to any of claims 12 to 15, wherein said through holes (7) are formed at intersection portions of lattice-like imaginary lines.

17. A method of manufacturing electronic devices comprising the steps:
(a) forming through holes (7) in a substrate material (6) along lattice-like imaginary lines;
(b) applying electrically conductive means to said through holes such that at least the wall defining each through hole becomes conductive;
(c) mounting electronic elements (1) in regions of said substrate material surrounded by said imaginary lines;
(d) establishing electrical connections between each electronic element and the corresponding through holes;
(e) applying molding resin (5) to the entire surface of said substrate material to mold said electronic elements; and
(f) cutting said substrate material, said molding resin and said through holes along said imaginary lines after said molding resin has been hardened.

18. The method according to claim 17 further comprising, prior to step (e), the step of (g) forming dams in the periphery of said substrate material (6) to prevent discharge of said molding resin (5).

19. The method according to claim 17 or 18, wherein said molding resin is hardened in a state where said substrate material (69 is held horizontally.

20. The method according to claim 18 or 19, wherein step (e) comprises controlling the amount of molding resin (5) applied by controlling the weight.

21. The method according to any of claims 17 to 20 further comprising, prior to step (e), the step of
(h) injecting a conductive paste into each of said through holes (7).

22. The method according to claim 21, wherein step (h) comprises heating and hardening said conductive paste after it has been injected into each of said through holes (7).

23. The method according to any of claims 17 to 20 further comprising, prior to step (e), the step of
(i) injecting a metal material (9) having solderability into each of said through holes (7).

24. The method according to claim 23, wherein said metal material is soldering paste, and step (i) comprises injecting the soldering paste into each of said through holes (7), and then heating and melting it.

25. The method according to claim 23, wherein said metal material is solder, and step (i) comprises melting said solder, causing the molten solder into a wave-like form and bringing opening portions of said through holes (7) into contact with said molten solder.

26. The method according to claim 23, wherein said metal material is solder, and step (i) comprises masking portions of said substrate material (6) except for opening portions of said through holes (7), and then immersing said substrate material into molten solder.

27. The method according to claim 23, wherein step (i) comprises applying a thick plating to said through holes.

28. The method according to any of claims 17 to 20 further comprising the steps of:
(j) closing, prior to step (e), an opening portion of each of said through holes (7) on the reverse surface of said substrate material (6) by applying a closing member (40; 50); and
(k) removing said closing member after said molding resin has been hardened.

29. The method according to claim 28, wherein said closing member is a non-adhesive flat member that is capable of covering the entire surface of the reverse side of said substrate material (6), and step (j) comprises pressing said flat member against the reverse side of said substrate material.

30. The method according to claim 29, wherein said flat member is made of silicon rubber.

31. The method according to claim 28, wherein said closing member is an adhesive sheet that is capable of covering the entire surface of the reverse side of said substrate material, and step (j) comprises applying and bonding said adhesive sheet to the reverse side of said substrate material (6).

32. The method according to claim 31, wherein said adhesive sheet is an ultraviolet hardening sheet, the adhesiveness of which deteriorates when irradiated with ultraviolet rays, and said ultraviolet hardening sheet is irradiated with ultraviolet rays after step (j) and before step (k).

33. The method according to claim 31, wherein said adhesive sheet is a thermosetting sheet, the adhesiveness of which deteriorates when heated, and said thermosetting sheet is heated after step (j) and before step (k).

34. The method according to claim 28, wherein said closing member is made of soluble resin that is dissolved in an alkali water solution, step (j) comprises introducing soluble resin into each of said through holes (7) and then hardening it, and step (k) comprises washing off said soluble resin with an alkali water solution.

35. The method according to any of claims 17 to 20 further comprising the step of
(l) attaching a covering material (70) to the surface of said substrate material, prior to step (e), for closing the opening portion of each of said through holes (7).

36. The method according to claim 35, wherein said covering material is an adhesive sheet or a dry film, and step (l) comprises applying said adhesive sheet or dry film and bonding it to the surface of said substrate material.

37. The method according to claim 35, wherein said covering material is a glass epoxy or ceramic molded plate, and step (l) comprises bonding said molded plate to the surface of said substrate material.

38. The method according to claim 35, wherein said covering member is made of a glass epoxy prepreg or a ceramic green sheet, and step (l) comprises forcibly applying said prepreg or green sheet, with heat, to the surface of said substrate material (6).

39. The method according to any of claims 17 to 38 further comprising the steps of:
(m) attaching, prior to step (e), to said substrate material, flatness-maintaining means for maintaining the flatness of said substrate material; and
(n) removing said flatness-maintaining means prior to step (f) and after said molding resin has been hardened.

40. The method according to claim 39, wherein said substrate material is heated and then gradually cooled prior to step (n) and after said molding resin has been hardened.

41. The method according to any of claims 17 to 38 further comprising the steps of:
(o) attaching, to said substrate material, flatness-maintaining means (80, 81) for maintaining the flatness of said substrate material (6), prior to step (f) and after said molding resin (5) has been hardened;
(p) heating and gradually cooling said substrate material; and
(q) removing said flatness-maintaining means.

42. The method according to any of claims 39 to 41, wherein said flatness-maintaining means comprises a flatness maintaining plate (80) that is placed on the reverse side of said substrate material (6), and a holding member (81) for holding both said flatness maintaining plate and said substrate material.

43. The method according to any of claims 17 to 42, wherein step (a) comprises integrally forming said through holes (7) and plating leads (92) connected to the corresponding through holes on said substrate material.

44. The method according to claim 43 further comprising the steps of:
(r) semi-cutting said substrate material (6) and said molding resin (5) to separate said plating leads from said through holes prior to performing step (f); and
(s) electrically inspecting said electronic elements (1).

45. The method according to claim 44, wherein said semi-cutting is performed along said imaginary lines.

46. The method according to any of claims 17 to 45 further comprising the step of:
(t) applying and boding an adhesive sheet to the entire surface of either side of said substrate material prior to performing step (f), wherein
step (f) is performed such that said sheet is not completely cut.
